# EUROPEAN PATENT APPLICATION

(11) **EP 4 726 723 A1**
(43) Date of publication of application: **15.04.2026**
(21) Application number: 25159091.5
(22) Date of filing: 20.02.2025
(51) Int. Cl.: G11C 11/4072, G11C 7/20, G11C 11/406

(54) **SEMICONDUCTOR MEMORY DEVICE AND INITIALIZATION METHOD THEREOF**

(30) Priority: 09.10.2024 TW 113138507
(71) Applicant: Winbond Electronics Corp., Taichung City (TW)
(72) Inventor: LIN, Che-Min, Taichung City (TW)
(74) Representative: Becker, Eberhard

(57) **Abstract**

A semiconductor memory device and an initialization method thereof are provided. The semiconductor memory device includes a memory array, a refresh controller, and an initialization controller. The memory array has a plurality of equalize circuits and N memory cells. The equalize circuits are respectively coupled to the N memory cells via a plurality of bit line pairs. The refresh controller is configured to refresh initial data in sequence to the N memory cells according to an auto-refresh command. The initialization controller is configured to perform an initialization operation according to an initialization activation command. The initialization controller enables the equalize circuits and periodically generates the auto-refresh command during the initialization operation.

## Description

### BACKGROUND

### Technical Field

The present invention relates to a method for operating a memory, and particularly relates to a semiconductor memory device and an initialization method thereof.

### Description of Related Art

When initializing a dynamic random access memory during activation, a turn on voltage is not applied to the word line, which keeps the access transistor in the memory cell in an off state. At this time, the amount of charge in each memory cell may not be fixed due to the influence of coupling, static electricity, or other effects. In this situation, when sensing the memory cell, the voltage on the bit line is difficult to enter a stable state, resulting in slow sensing speed and higher power consumption, and there is even a chance of sensing failure.

### SUMMARY

The present invention provides a semiconductor memory device and an initialization method thereof, which can make the memory cell have a stable charge amount (voltage) during the initialization operation of the semiconductor memory device.

The semiconductor memory device of the present invention includes a memory array, a refresh controller, and an initialization controller. The memory array has a plurality of equalize circuits and N memory cells. The equalize circuits are respectively coupled to N memory cells via a plurality of bit line pairs, where N is a positive integer greater than 1. The refresh controller is coupled to the memory array and configured to refresh initial data in sequence to N memory cells according to an auto-refresh command. The initialization controller is coupled to the memory array and the refresh controller, and configured to perform an initialization operation according to an initialization activation command. The initialization controller enables the equalize circuits and periodically generates the auto-refresh command during the initialization operation.

The initialization method for a semiconductor memory device of the present invention is applicable to the semiconductor memory device including the aforementioned memory array. The initialization method includes the following steps: performing an initialization operation according to an initialization activation command; during the initialization operation, enabling the equalize circuits and periodically generating an auto-refresh command; and refreshing initial data in sequence to the N memory cells according to the auto-refresh command.

The semiconductor memory device and the initialization method thereof of the present invention can refresh initial data to the memory cells during the initialization operation, thereby making the memory cells have a stable charge amount. When performing a specified operation afterwards, it may allow the voltage on the bit line to quickly enter a stable state, thereby improving sensing speed and reducing power consumption, effectively avoiding the situation of sensing failure.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 illustrates a block diagram of a semiconductor memory device according to an embodiment of the present invention.
FIG. 2 illustrates a circuit diagram of a memory array according to an embodiment of the present invention.
FIG. 3 illustrates a block diagram of an initialization controller according to an embodiment of the present invention.
FIG. 4 illustrates a flowchart of steps of an initialization method according to an embodiment of the present invention.

### DESCRIPTION OF THE EMBODIMENTS

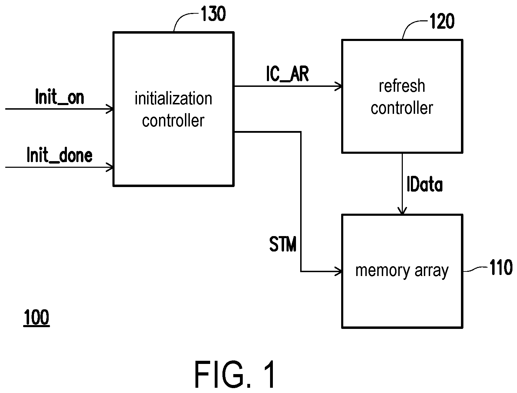

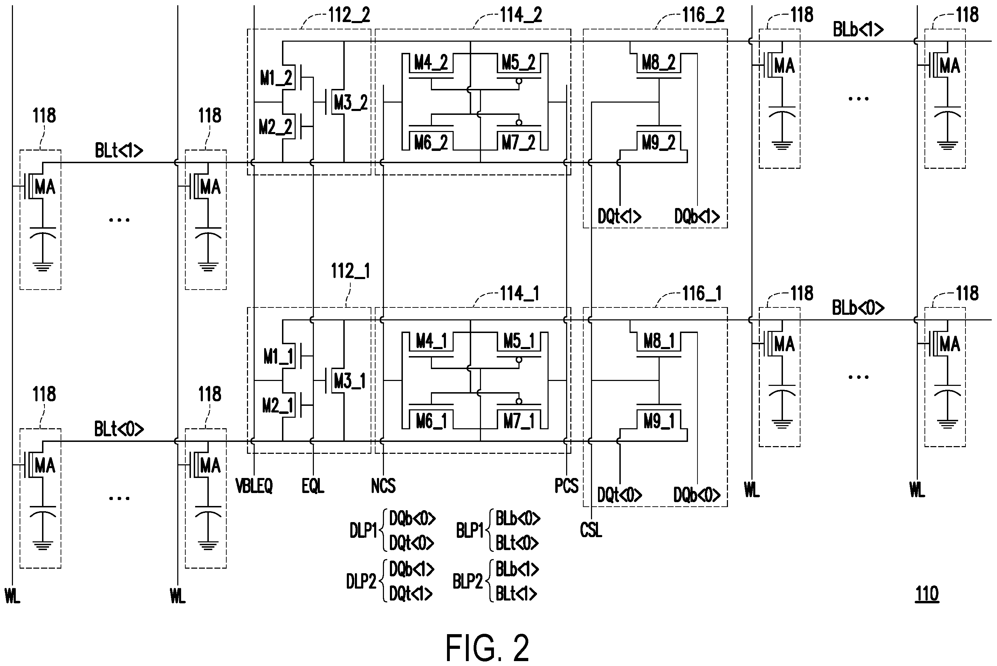

Referring to FIG. 1, the semiconductor memory device 100 of the present invention includes a memory array 110, a refresh controller 120, and an initialization controller 130. The memory array 110 is, for example, an array constituted by dynamic random access memory. As shown in FIG. 2, the memory array 110 includes equalize circuits 112_1, 112_2, sense amplifier circuits 114_1, 114_2, selection circuits 116_1, 116_2, and N memory cells 118. N is a positive integer greater than 1.

The equalize circuits 112_1, 112_2 are coupled to N memory cells 118 via bit line pairs BLP1, BLP2 respectively. Specifically, in FIG. 2, the bit line pair BLP1 includes a first bit line BLb<0> and a second bit line BLt<0>, and the bit line pair BLP2 includes a first bit line BLb<1> and a second bit line BLt<1>. The equalize circuit 112_1 includes transistors M1_1~M3_1. The first terminal of transistor M1_1 is coupled to the first bit line BLb<0>, the second terminal of transistor M1_1 receives an equalize voltage VBLEQ, and the control terminal of transistor M1_1 receives an equalize signal EQL. The first terminal of transistor M2_1 is coupled to the second terminal of transistor M1_1, the second terminal of transistor M2_1 is coupled to the second bit line BLt<0>, and the control terminal of transistor M2_1 receives the equalize signal EQL. The first terminal of transistor M3_1 is coupled to the first bit line BLb<0>, the second terminal of transistor M3_1 is coupled to the second bit line BLt<0>, and the control terminal of transistor M3_1 receives the equalize signal EQL. The equalize circuit 112_2 includes transistors M1_2~M3_2, which are coupled in a similar manner to transistors M1_1~M3_1 of the equalize circuit 112_1. Transistors M1_1~M3_1, M1_2~M3_2 may, for example, be implemented as N-type MOSFETs (Metal-Oxide-Semiconductor Field-Effect Transistors).

Each equalize circuit 112_1, 112_2 may receive an equalize signal EQL from the initialization controller 130. When the equalize signal EQL transitions to an enable level (e.g., high logic level), the transistors M1_1~M3_1 in the equalize circuit 112_1 and the transistors M1_2~M3_2 in the equalize circuit 112_2 will turn on. As such, the equalize circuit 112_1 may utilize the equalize voltage VBLEQ to control the voltage on the first bit line BLb<0> to be consistent with the voltage on the second bit line BLt<0>, and the equalize circuit 112_2 may utilize the equalize voltage VBLEQ to control the voltage on the first bit line BLb<1> to be consistent with the voltage on the second bit line BLt<1>.

The sense amplifier circuits 114_1, 114_2 are similarly coupled to N memory cells 118 via bit line pairs BLP1, BLP2 respectively. The sense amplifier circuit 114_1 includes transistors M4_1~M7_1. The first terminal of transistor M4_1 receives the first sense control voltage NCS, the second terminal of transistor M4_1 is coupled to the first bit line BLb<0>, and the control terminal of transistor M4_1 is coupled to the second bit line BLt<0>. The first terminal of transistor M5_1 is coupled to the first bit line BLb<0>, the second terminal of transistor M5_1 receives the second sense control voltage PCS, and the control terminal of transistor M5_1 is coupled to the second bit line BLt<0>. The first terminal of transistor M6_1 receives the first sense control voltage NCS, the second terminal of transistor M6_1 is coupled to the second bit line BLt<0>, and the control terminal of transistor M6_1 is coupled to the first bit line BLb<0>. The first terminal of transistor M7_1 is coupled to the second bit line BLt<0>, the second terminal of transistor M7_1 receives the second sense control voltage PCS, and the control terminal of transistor M7_1 is coupled to the first bit line BLb<0>. The sense amplifier circuit 114_2 includes transistors M4_2~M7_2, which are coupled in a similar manner to the transistors M4_1~M7_1 of the sense amplifier circuit 114_1. For example, transistors M4_1, M6_1, M4_2, M6_2 may be implemented as N-type MOSFETs, while transistors M5_1, M7_1, M5_2, M7_2 may be implemented as P-type MOSFETs.

In the situation where the sense amplifier circuits 114_1, 14_2 are sensing the N memory cells 118, the first sense control voltage NCS is set to the voltage of logic 0 (e.g., low logic level), and the second sense control voltage PCS is set to the voltage of logic 1. As such, the sense amplifier circuits 114_1, 14_2 may utilize the first sense control voltage NCS and the second sense control voltage PCS to respectively drive the voltages on the bit line pairs BLP1, BLP2 to enter a stable state.

The selection circuit 116_1 is coupled between the bit line pair BLP1 and the data line pair DLP1. Specifically, the data line pair DLP1 includes a first data line DQb<0> and a second data line DQt<0>. The selection circuit 116_1 includes transistors M8_1, M9_1. The first terminal of transistor M8_1 is coupled to the first bit line BLb<0>, the second terminal of transistor M8_1 is coupled to the first data line DQb<0>, and the control terminal of transistor M8_1 receives the column select signal CSL. The first terminal of transistor M9_1 is coupled to the second bit line BLt<0>, the second terminal of transistor M9_1 is coupled to the second data line DQt<0>, and the control terminal of transistor M9_1 receives the column select signal CSL. When the memory cell 118 coupled to the bit line pair BLP1 is selected for a specified operation (such as a write operation or a read operation), the column select signal CSL may turn on transistors M8_1, M9_1 to turn on the transmission path between the bit line pair BLP1 and the data line pair DLP1. Transistors M8_1, M9_1 may, for example, be implemented as N-type MOSFETs.

The selection circuit 116_2 is coupled between the bit line pair BLP2 and the data line pair DLP2. The data line pair DLP2 includes a first data line DQb<1> and a second data line DQt<1>. The selection circuit 116_2 includes transistors M8_2, M9_2. The first terminal of transistor M8_2 is coupled to the first bit line BLb<1>, the second terminal of transistor M8_2 is coupled to the first data line DQb<1>, and the control terminal of transistor M8_2 receives the column select signal CSL. The first terminal of transistor M9_2 is coupled to the second bit line BLt<1>, the second terminal of transistor M9_2 is coupled to the second data line DQt<1>, and the control terminal of transistor M9_2 receives the column select signal CSL. When the memory cell 118 coupled to the bit line pair BLP2 is selected for a specified operation, the column select signal CSL may turn on transistors M8_2, M9_2 to turn on the transmission path between the bit line pair BLP2 and the data line pair DLP2. Transistors M8_2, M9_2 may, for example, be implemented as N-type MOSFETs.

Referring back to FIG. 1, the refresh controller 120 is coupled to the memory array 110. The refresh controller 120 is configured to refresh the initial data IData in sequence to N memory cells 118 in the memory array 110 according to the auto-refresh command IC_AR. The initialization controller 130 is coupled to the memory array 110 and the refresh controller 120. The initialization controller 130 is configured to output an initialization signal STM to the memory array 110 according to the initialization activation command Init_on to begin the initialization operation. The initialization activation command Init_on may, for example, be a command output by the memory controller indicating that initialization should be performed when the semiconductor memory device 100 is activated. The initial data IData may, for example, be data representing logic 0, and the voltage of the memory cell 118 storing the initial data IData may, for example, be ground voltage (e.g., 0 volts). The advantage of this is that, when the memory cell 118 is selected for a specified operation later, the turn on voltage Von applied to the corresponding word line WL does not need to be too high (theoretically, it only needs to be greater than the threshold voltage of the access transistor MA), which may improve operational convenience.

During the initialization operation, the initialization controller 130 may enable the equalize circuits 112_1, 112_2 in the memory array 110, and disable the sense amplifier circuits 114_1, 114_2 in the memory array 110, while periodically generating the auto-refresh command IC_AR.

The initialization signal STM output by the initialization controller 130 may include at least the equalize signal EQL and equalize voltage VBLEQ used by each equalize circuit 112_1, 112_2, the first sense control voltage NCS and the second sense control voltage PCS used by each sense amplifier circuit 114_1, 114_2, and the turn on voltage Von used to turn on the access transistor MA in the memory cell 118. During the initialization operation, the initialization controller 130 may maintain the equalize signal EQL at the enable level, and set the equalize voltage VBLEQ equal to the ground voltage. Thereby, the equalize circuits 112_1, 112_2 are enabled.

Moreover, during the initialization operation, the initialization controller 130 may set the first sense control voltage NCS and the second sense control voltage PCS equal to the ground voltage. Thereby, the sense amplifier circuits 114_1, 114_2 are disabled, and leakage current may be avoided.

During the initialization operation, the initialization controller 130 may set the initial value of K to 1. Whenever the initialization controller 130 generates the auto-refresh command IC_AR, the initialization controller 130 may simultaneously turn on multiple access transistors MA in the Kth memory cell to the (K+J)th memory cell among the N memory cells 118, then increment K by J+1 (K=K+J+1), until K is greater than N or until the initialization controller 130 receives the initialization termination command Init_done. J is a positive integer greater than or equal to 1. Furthermore, the refresh controller 120 may operate in conjunction with the initialization controller 130. Whenever the refresh controller 120 receives the auto-refresh command IC_AR generated by the initialization controller 130, the refresh controller 120 may refresh the initial data IData from the Kth memory cell to the (K+J)th memory cell among the N memory cells 118.

In a situation where J equals 3, when the auto-refresh command IC_AR is generated for the first time (K equals 1), the initialization controller 130 may provide the turn on voltage Von to the word lines WL corresponding to the 1st memory cell 118 to the 4th memory cell 118 to be refreshed, thereby simultaneously turning on the access transistors MA in the 1st memory cell 118 to the 4th memory cell 118, and then increment K to 5. Moreover, the refresh controller 120 that receives this auto-refresh command IC_AR may simultaneously refresh the initial data IData to the 1st memory cell 118 to the 4th memory cell 118. When the auto-refresh command IC_AR is generated for the second time (K equals 5), the initialization controller 130 may provide the turn on voltage Von to the word lines WL corresponding to the 5th memory cell 118 to the 8th memory cell 118 to be refreshed, thereby simultaneously turning on the access transistors MA in the 5th memory cell 118 to the 8th memory cell 118, and then increment K to 9. Moreover, the refresh controller 120 that receives this auto-refresh command IC_AR may simultaneously refresh the initial data IData to the 5th memory cell 118 to the 8th memory cell 118. This process continues until K accumulates to a value greater than N (indicating that the access transistors MA in all memory cells 118 have been turned on) or until the initialization controller 130 receives the initialization termination command Init_done. The initialization termination command Init_done may be, for example, a command output by the memory controller indicating the termination of initialization.

In this embodiment, the value of J may correspond to the number of memory cells 118 that are refreshed simultaneously. Those skilled in the art may adjust the value of J appropriately based on their actual requirements and by referring to the teachings of this embodiment.

Through the aforementioned operation, it may be possible to ensure that all memory cells have a stable charge amount as much as possible during the initialization operation of the semiconductor memory device. As a result, after the initialization is completed, even when sensing the memory cells for the first time, it may eliminate unstable factors formed by coupling, static electricity, or other effects, allowing the voltage on the bit lines to quickly enter the stable state, thereby improving sensing speed and reducing power consumption, effectively avoiding situations of sensing failure.

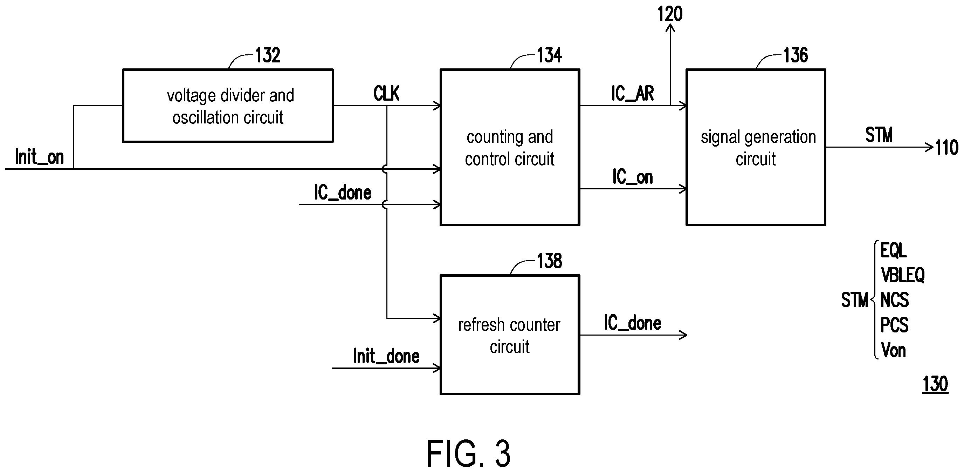

The following example illustrates the internal composition of the initialization controller 130. Please refer to FIG. 3, the initialization controller 130 includes a voltage divider and oscillation circuit 132, a counting and control circuit 134, a signal generation circuit 136, and a refresh counter circuit 138. The voltage divider and oscillation circuit 132 may be configured to receive the initialization activation command Init_on, and in response to the initialization activation command Init_on, activate to generate a clock signal CLK. When the voltage divider and oscillation circuit 132 receives the initialization activation command Init_on, it may start generating the clock signal CLK at a predetermined period.

The counting and control circuit 134 may be coupled to the voltage divider and oscillation circuit 132. The counting and control circuit 134 may be configured to receive the initialization activation command Init_on and the clock signal CLK. The counting and control circuit 134 may output a refresh activation command IC_on in response to the initialization activation command Init_on. When receiving the initialization activation command Init_on, the counting and control circuit 134 may output the refresh activation command IC_on to the signal generation circuit 136.

The counting and control circuit 134 may count the clock signal CLK to accumulate a first count value. Whenever the first count value accumulates to a first predetermined number of times, the counting and control circuit 134 may reset the first count value to zero and output an auto-refresh command IC_AR to the refresh controller 120 and the signal generation circuit 136. The magnitude of the first predetermined number of times may depend on the delay time required for the refresh controller 120 to refresh the initial data IData from the Kth memory cell to the (K+J)th memory cell among the N memory cells 118.

The signal generation circuit 136 may be coupled to the counting and control circuit 134. The signal generation circuit 136 may be configured to receive the refresh activation command IC_on and the auto-refresh command IC_AR. The signal generation circuit 136 may provide an initialization signal STM to the memory array 110 based on the refresh activation command IC_on and the auto-refresh command IC_AR. Specifically, when receiving the refresh activation command IC_on, the signal generation circuit 136 may provide an equalize signal EQL at an enable level and an equalize voltage VBLEQ set equal to the ground voltage to the equalize circuits 112_1, 112_2 in the memory array 110, and provide a first sense control voltage NCS and a second sense control voltage PCS set equal to the ground voltage to the sense amplifier circuits 114_1, 114_2 in the memory array 110. Furthermore, whenever receiving the auto-refresh command IC_AR, the signal generation circuit 136 may provide a turn on voltage Von to the word line WL corresponding to the memory cells 118 to be refreshed.

The refresh counter circuit 138 may be coupled to the voltage divider and oscillation circuit 132 and the counting and control circuit 134. The refresh counter circuit 138 may be configured to receive the clock signal CLK. The refresh counter circuit 138 may count the clock signal CLK to accumulate a second count value. When the second count value accumulates to a second predetermined number of times, it indicates that all memory cells 118 in the memory array 110 have been refreshed. At this time, the refresh counter circuit 138 may output a refresh termination command IC_done to the counting and control circuit 134. The magnitude of the second predetermined number of times may depend on the delay time required to refresh all memory cells 118 in the memory array 110.

When the counting and control circuit 134 receives the refresh termination command IC_done, the counting and control circuit 134 may stop outputting the auto-refresh command IC_AR in response to the refresh termination command IC_done. As a result, the refresh controller 120 may stop refreshing the initial data IData to the memory cells 118 in the memory array 110, and terminate the initialization operation.

When the refresh counter circuit 138 receives the initialization termination command Init_done, it may also output the refresh termination command IC_done to the counting and control circuit 134. As a result, even if there are still memory cells 118 in the memory array 110 that have not completed refreshing, the initialization operation may be terminated in real-time according to the situation, thereby avoiding interference with the startup process of the semiconductor memory device 100.

The refresh controller 120 and the initialization controller 130 may be implemented using digital circuits, and the related hardware architecture may be generated using digital circuit design methods well-known to those skilled in the art, without specific limitations.

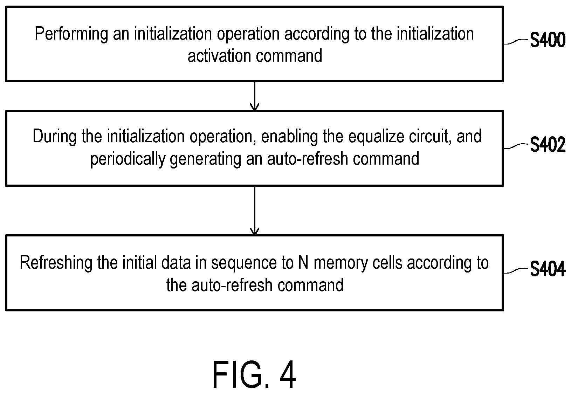

Please refer to FIG. 4, the initialization method of the semiconductor memory device includes the following steps. Performing an initialization operation according to the initialization activation command (step S400). During the initialization operation, enabling the equalize circuit, and periodically generating an auto-refresh command (step S402). Refreshing the initial data in sequence to N memory cells according to the auto-refresh command (step S404). The implementation details of the above steps S400 to S404 may refer to the embodiments of FIG. 1 to FIG. 3, and will not be repeated here.

In summary, during the initialization operation, the equalize voltage used by the equalize circuit and the sense control voltage used by the sense amplifier circuit are adjusted, and the initial data is refreshed to the memory cells, thereby providing the memory cells with a stable amount of charge. Subsequently, when performing specified operations, unstable factors formed by coupling, static electricity, or other effects can be eliminated, allowing the voltage on the bit lines to quickly enter a stable state, thereby improving sensing speed and reducing power consumption, effectively avoiding sensing failure situations.

## Claims

1. A semiconductor memory device (100), comprising:
a memory array (110), having a plurality of equalize circuits (112_1, 112_2) and N memory cells (118), the equalize circuits (112_1, 112_2) are respectively coupled to the N memory cells (118) via a plurality of bit line pairs (BLP1, BLP2), wherein N is a positive integer greater than 1;
a refresh controller (120), coupled to the memory array (110), configured to refresh initial data (IData) in sequence to the N memory cells (118) according to an auto-refresh command (IC_AR); and
an initialization controller (130), coupled to the memory array (110) and the refresh controller (120), configured to perform an initialization operation according to an initialization activation command (Init_on),
wherein, during the initialization operation, the initialization controller (130) enables the equalize circuits (112_1, 112_2), and periodically generates the auto-refresh command (IC_AR).

2. The semiconductor memory device (100) as claimed in claim 1, wherein during the initialization operation, the initialization controller (130) sets an initial value of K to 1, whenever the auto-refresh command (IC_AR) is generated, the initialization controller (130) simultaneously turns on a plurality of access transistors in the Kth memory cell to the (K+J)th memory cell among the N memory cells (118), then increments K by J+1, until K is greater than N or the initialization controller (130) receives an initialization termination command (Init_done), wherein J is a positive integer greater than or equal to 1.

3. The semiconductor memory device (100) as claimed in claim 2, wherein whenever the auto-refresh command (IC_AR) is received, the refresh controller (120) refreshes the initial data (IData) from the Kth memory cell to the (K+J)th memory cell among the N memory cells (118).

4. The semiconductor memory device (100) as claimed in claim 1, wherein each of the bit line pairs (BLP1, BLP2) comprises a first bit line and a second bit line, each of the equalize circuits (112_1, 112_2) receives an equalize signal (EQL) from the initialization controller (130), when the equalize signal (EQL) transitions to an enable level, each of the equalize circuits (112_1, 112_2) utilizes an equalize voltage to control a voltage on the corresponding first bit line and a voltage on the corresponding second bit line.

5. The semiconductor memory device (100) as claimed in claim 4, wherein during the initialization operation, the initialization controller (130) maintains the equalize signal (EQL) at the enable level and sets the equalize voltage to be equal to a ground voltage.

6. The semiconductor memory device (100) as claimed in claim 1, wherein the memory array (110) further comprises a plurality of sense amplifier circuits (114_1, 114_2), the sense amplifier circuits (114_1, 114_2) are respectively coupled to the N memory cells (118) via the bit line pairs (BLP1, BLP2),
during the initialization operation, the initialization controller (130) disables the sense amplifier circuits (114_1, 114_2).

7. The semiconductor memory device (100) as claimed in claim 6, wherein in a situation where the sense amplifier circuits (114_1, 114_2) sense the N memory cells (118), each of the sense amplifier circuits (114_1, 114_2) utilizes a first sense control voltage and a second sense control voltage to bring a voltage on the corresponding bit line pair into a stable state.

8. The semiconductor memory device (100) as claimed in claim 7, wherein during the initialization operation, the initialization controller (130) sets the first sense control voltage and the second sense control voltage to be equal to a ground voltage.

9. The semiconductor memory device (100) as claimed in claim 6, wherein the initialization controller (130) includes:
a voltage divider and oscillation circuit (132), configured to receive the initialization activation command (Init_on), and activate in response to the initialization activation command (Init_on) to generate a clock signal;
a counting and control circuit (134), coupled to the voltage divider and oscillation circuit (132), configured to receive the initialization activation command (Init_on) and the clock signal, output a refresh activation command in response to the initialization activation command (Init_on), and count the clock signal to accumulate a first count value, whenever the first count value accumulates to a first predetermined number of times, reset the first count value to zero and output the auto-refresh command (IC_AR); and
a signal generation circuit (136), coupled to the counting and control circuit (134), configured to receive the refresh activation command and the auto-refresh command (IC_AR), according to the refresh activation command, during the initialization operation, an equalize signal (EQL) and an equalize voltage used by each of the equalize circuits (112_1, 112_2) and a first sense control voltage and a second sense control voltage used by each of the sense amplifier circuits (114_1, 114_2) are provided, and according to the auto-refresh command (IC_AR), provide a turn on voltage to a plurality of word lines corresponding to the memory cells (118) to be refreshed.

10. The semiconductor memory device (100) as claimed in claim 9, further comprising:
a refresh counter circuit (138), coupled to the voltage divider and oscillation circuit (132) and the counting and control circuit (134), configured to receive the clock signal, count the clock signal to accumulate a second count value, when the second count value accumulates to a second predetermined number of times, output a refresh termination command to the counting and control circuit (134),
the counting and control circuit (134) stops outputting the auto-refresh command (IC_AR) in response to the refresh termination command.

11. The semiconductor memory device (100) as claimed in claim 10, wherein when the refresh counter circuit (138) receives an initialization termination command (Init_done), the refresh counter circuit (138) outputs the refresh termination command to the counting and control circuit (134).

12. An initialization method for a semiconductor memory device (100), the semiconductor memory device (100) including a memory array (110), the memory array (110) having a plurality of equalize circuits (112_1, 112_2) and N memory cells (118), wherein N is a positive integer greater than 1, the initialization method comprising the following steps:
performing (S400) an initialization operation according to an initialization activation command (Init_on);
during the initialization operation, enabling (S402) the equalize circuits (112_1, 112_2), and periodically generating an auto-refresh command (IC_AR); and
refreshing (S404) initial data (IData) in sequence to the N memory cells (118) according to the auto-refresh command (IC_AR).

13. The initialization method as claimed in claim 12, further comprising:
during the initialization operation, setting an initial value of K to 1; and
whenever the auto-refresh command (IC_AR) is generated, simultaneously turning on a plurality of access transistors in the Kth memory cell to the (K+J)th memory cell among the N memory cells (118), then incrementing K by J+1, until K is greater than N or an initialization termination command (Init_done) is received, wherein J is a positive integer greater than or equal to 1.

14. The initialization method as claimed in claim 13, wherein the step of refreshing the initial data (IData) in sequence to the N memory cells (118) according to the auto-refresh command (IC_AR) comprises:
whenever the auto-refresh command (IC_AR) is received, refreshing the initial data (IData) from the Kth memory cell to the (K+J)th memory cell among the N memory cells (118).

15. The initialization method as claimed in claim 12, wherein the equalize circuits (112_1, 112_2) are respectively coupled to the N memory cells (118) via a plurality of bit line pairs (BLP1, BLP2), when an equalize signal (EQL) transitions to an enable level, each of the equalize circuits (112_1, 112_2) utilizes an equalize voltage to control a voltage on the corresponding bit line pairs (BLP1, BLP2),
wherein the step of enabling the equalize circuits (112_1, 112_2) comprises:
maintaining the equalize signal (EQL) at the enable level; and
setting the equalize voltage to be equal to a ground voltage.

16. The initialization method as claimed in claim 12, wherein the memory array (110) further comprises a plurality of sense amplifier circuits (114_1, 114_2), the initialization method further comprises:
during the initialization operation, disabling the sense amplifier circuits (114_1, 114_2).

17. The initialization method as claimed in claim 16, wherein the sense amplifier circuits (114_1, 114_2) are respectively coupled to the N memory cells (118) via a plurality of bit line pairs (BLP1, BLP2), in a situation where the sense amplifier circuits (114_1, 114_2) sense the N memory cells (118), each of the sense amplifier circuits (114_1, 114_2) utilizes a first sense control voltage and a second sense control voltage to bring a voltage on the corresponding bit line pair into a stable state,
wherein the step of disabling the sense amplifier circuits (114_1, 114_2) comprises:
during the initialization operation, setting the first sense control voltage and the second sense control voltage to be equal to a ground voltage.

## Amended claims

### Amended claims in accordance with Rule 137(2) EPC.

1. A semiconductor memory device (100), comprising:
a memory array (110), having a plurality of equalize circuits (112_1, 112_2) and N memory cells (118), the equalize circuits (112_1, 112_2) are respectively coupled to the N memory cells (118) via a plurality of bit line pairs (BLP1, BLP2), wherein N is a positive integer greater than 1;
a refresh controller (120), coupled to the memory array (110), configured to refresh initial data (IData) in sequence to the N memory cells (118) according to an auto-refresh command (IC_AR); and
an initialization controller (130), coupled to the memory array (110) and the refresh controller (120), configured to perform an initialization operation according to an initialization activation command (Init_on),
wherein, during the initialization operation, the initialization controller (130) enables the equalize circuits (112_1, 112_2), and periodically generates the auto-refresh command (IC_AR),
wherein during the initialization operation, the initialization controller (130) sets an initial value of K to 1, whenever the auto-refresh command (IC_AR) is generated, the initialization controller (130) simultaneously turns on a plurality of access transistors in the Kth memory cell to the (K+J)th memory cell among the N memory cells (118), then increments K by J+1, until K is greater than N or the initialization controller (130) receives an initialization termination command (Init_done), wherein J is a positive integer greater than or equal to 1.

2. The semiconductor memory device (100) as claimed in claim 1, wherein whenever the auto-refresh command (IC_AR) is received, the refresh controller (120) refreshes the initial data (IData) from the Kth memory cell to the (K+J)th memory cell among the N memory cells (118).

3. The semiconductor memory device (100) as claimed in claim 1, wherein each of the bit line pairs (BLP1, BLP2) comprises a first bit line and a second bit line, each of the equalize circuits (112_1, 112_2) receives an equalize signal (EQL) from the initialization controller (130), when the equalize signal (EQL) transitions to an enable level, each of the equalize circuits (112_1, 112_2) utilizes an equalize voltage to control a voltage on the corresponding first bit line and a voltage on the corresponding second bit line.

4. The semiconductor memory device (100) as claimed in claim 3, wherein during the initialization operation, the initialization controller (130) maintains the equalize signal (EQL) at the enable level and sets the equalize voltage to be equal to a ground voltage.

5. The semiconductor memory device (100) as claimed in claim 1, wherein the memory array (110) further comprises a plurality of sense amplifier circuits (114_1, 114_2), the sense amplifier circuits (114_1, 114_2) are respectively coupled to the N memory cells (118) via the bit line pairs (BLP1, BLP2),
during the initialization operation, the initialization controller (130) disables the sense amplifier circuits (114_1, 114_2).

6. The semiconductor memory device (100) as claimed in claim 5, wherein in a situation where the sense amplifier circuits (114_1, 114_2) sense the N memory cells (118), each of the sense amplifier circuits (114_1, 114_2) utilizes a first sense control voltage and a second sense control voltage to bring a voltage on the corresponding bit line pair into a stable state.

7. The semiconductor memory device (100) as claimed in claim 6, wherein during the initialization operation, the initialization controller (130) sets the first sense control voltage and the second sense control voltage to be equal to a ground voltage.

8. The semiconductor memory device (100) as claimed in claim 5, wherein the initialization controller (130) includes:
a voltage divider and oscillation circuit (132), configured to receive the initialization activation command (Init_on), and activate in response to the initialization activation command (Init_on) to generate a clock signal;
a counting and control circuit (134), coupled to the voltage divider and oscillation circuit (132), configured to receive the initialization activation command (Init_on) and the clock signal, output a refresh activation command in response to the initialization activation command (Init_on), and count the clock signal to accumulate a first count value, whenever the first count value accumulates to a first predetermined number of times, reset the first count value to zero and output the auto-refresh command (IC_AR); and
a signal generation circuit (136), coupled to the counting and control circuit (134), configured to receive the refresh activation command and the auto-refresh command (IC_AR), according to the refresh activation command, during the initialization operation, an equalize signal (EQL) and an equalize voltage used by each of the equalize circuits (112_1, 112_2) and a first sense control voltage and a second sense control voltage used by each of the sense amplifier circuits (114_1, 114_2) are provided, and according to the auto-refresh command (IC_AR), provide a turn on voltage to a plurality of word lines corresponding to the memory cells (118) to be refreshed.

9. The semiconductor memory device (100) as claimed in claim 8, further comprising:
a refresh counter circuit (138), coupled to the voltage divider and oscillation circuit (132) and the counting and control circuit (134), configured to receive the clock signal, count the clock signal to accumulate a second count value, when the second count value accumulates to a second predetermined number of times, output a refresh termination command to the counting and control circuit (134),
the counting and control circuit (134) stops outputting the auto-refresh command (IC_AR) in response to the refresh termination command.

10. The semiconductor memory device (100) as claimed in claim 9, wherein when the refresh counter circuit (138) receives an initialization termination command (Init_done), the refresh counter circuit (138) outputs the refresh termination command to the counting and control circuit (134).

11. An initialization method for a semiconductor memory device (100), the semiconductor memory device (100) including a memory array (110), the memory array (110) having a plurality of equalize circuits (112_1, 112_2) and N memory cells (118), wherein N is a positive integer greater than 1, the initialization method comprising the following steps:
performing (S400) an initialization operation according to an initialization activation command (Init_on);
during the initialization operation, enabling (S402) the equalize circuits (112_1, 112_2), and periodically generating an auto-refresh command (IC_AR); and
refreshing (S404) initial data (IData) in sequence to the N memory cells (118) according to the auto-refresh command (IC_AR),
wherein the initialization method further comprises:
during the initialization operation, setting an initial value of K to 1; and
whenever the auto-refresh command (IC_AR) is generated, simultaneously turning on a plurality of access transistors in the Kth memory cell to the (K+J)th memory cell among the N memory cells (118), then incrementing K by J+1, until K is greater than N or an initialization termination command (Init_done) is received, wherein J is a positive integer greater than or equal to 1.

12. The initialization method as claimed in claim 11, wherein the step of refreshing the initial data (IData) in sequence to the N memory cells (118) according to the auto-refresh command (IC_AR) comprises:
whenever the auto-refresh command (IC_AR) is received, refreshing the initial data (IData) from the Kth memory cell to the (K+J)th memory cell among the N memory cells (118).

13. The initialization method as claimed in claim 11, wherein the equalize circuits (112_1, 112_2) are respectively coupled to the N memory cells (118) via a plurality of bit line pairs (BLP1, BLP2), when an equalize signal (EQL) transitions to an enable level, each of the equalize circuits (112_1, 112_2) utilizes an equalize voltage to control a voltage on the corresponding bit line pairs (BLP1, BLP2),
wherein the step of enabling the equalize circuits (112_1, 112_2) comprises:
maintaining the equalize signal (EQL) at the enable level; and
setting the equalize voltage to be equal to a ground voltage.

14. The initialization method as claimed in claim 11, wherein the memory array (110) further comprises a plurality of sense amplifier circuits (114_1, 114_2), the initialization method further comprises:
during the initialization operation, disabling the sense amplifier circuits (114_1, 114_2).

15. The initialization method as claimed in claim 14, wherein the sense amplifier circuits (114_1, 114_2) are respectively coupled to the N memory cells (118) via a plurality of bit line pairs (BLP1, BLP2), in a situation where the sense amplifier circuits (114_1, 114_2) sense the N memory cells (118), each of the sense amplifier circuits (114_1, 114_2) utilizes a first sense control voltage and a second sense control voltage to bring a voltage on the corresponding bit line pair into a stable state,
wherein the step of disabling the sense amplifier circuits (114_1, 114_2) comprises:
during the initialization operation, setting the first sense control voltage and the second sense control voltage to be equal to a ground voltage.
